# EUROPÄISCHE PATENTSCHRIFT

(11) **EP 1 344 245 B1**
(45) Veröffentlichungstag und Bekanntmachung des Hinweises auf die Patenterteilung: **14.03.2007**
(21) Anmeldenummer: 00991238.7
(22) Anmeldetag: 21.12.2000
(51) Int. Cl.: H01L 21/033, H01L 21/768, H01L 21/60, H01L 21/308, H01L 21/336

(54) **VERFAHREN ZUM HERSTELLEN EINES EINE MIKROSTRUKTUR AUFWEISENDEN FESTKÖRPERS**
METHOD FOR PRODUCING A SOLID BODY COMPRISING A MICROSTRUCTURE
PROCEDE POUR REALISER UN CORPS SOLIDE DOTE D'UNE MICROSTRUCTURE

(43) Veröffentlichungstag der Anmeldung: 17.09.2003
(73) Patentinhaber: Micronas GmbH, 79108 Freiburg i. Br. (DE)
(72) Erfinder: IGEL, Günter, 79331 Teningen (DE); LEHMANN, Mirko, 79102 Freiburg (DE)
(74) Vertreter: Huwer, Andreas
(86) Internationale Anmeldenummer: PCT/EP2000/013066
(87) Internationale Veröffentlichungsnummer: WO 2002/050878

(56) Entgegenhaltungen:
- EP-A- 0 412 263
- US-A- 5 171 705
- "METHOD OF FORMING A SUBSTRATE CONTACT FOR A BIPOLAR MEMORY CELL" IBM TECHNICAL DISCLOSURE BULLETIN, Bd. 27, Nr. 11, April 1985 (1985-04), Seiten 6533-6536, XP000806676 IBM CORP, NEW YORK, USA ISSN: 0018-8689
- PATENT ABSTRACTS OF JAPAN vol. 014, no. 257 (E-0936), 4. Juni 1990 (1990-06-04) -& JP 02 077135 A (NEC CORP), 16. März 1990 (1990-03-16)

## Beschreibung

Die Erfindung betrifft ein Verfahren zum Herstellen eines eine Mikrostruktur aufweisenden Festkörpers, insbesondere eines Halbleiterbauelements, wobei die Oberfläche eines Substrats mit einer für eine aufzubringende Substanz undurchlässigen Maskierungsschicht versehen und die Substanz danach in von der Maskierungsschicht nicht bedeckte Substratbereiche eingebracht wird.

Ein derartiges Verfahren ist aus dem Buch Integrierte Digitalbausteine, Siemens AG (1970), Seite 12 und 13 bekannt. Dabei wird zum Herstellen eines Halbleiterbauelement ein Oberflächenbereichs eines Silizium-Substrats mit einer für einen Dotierungsstoff undurchlässigen, aus Silizium dioxid bestehenden Maskierungsschicht abgedeckt, während andere Oberflächenbereiche frei bleiben. Zum Erzeugen der Maskierungsschicht wird das Substrat zunächst in einem Sauerstoffstrom angeordnet, wobei sich an der Oberfläche des Substrats eine durchgehende Siliziumdioxid-Schicht ausbildet. Danach wird ein lichtempfindlicher Photolack auf die Substratoberfläche aufgetragen. Dieser Photolack wird durch eine Photomaske hindurch belichtet, die an den Stellen lichtdurchlässig ist, an denen das Substrat für die Dotierung offen bleiben soll. Nach dem Belichten wird der Photolack an den belichteten Stellen mit einem Lösungsmittel entfernt, während die für das Lösungsmittel unlöslichen unbelichteten Bereiche des Photolacks auf dem Substrat verbleiben. Mit einem Ätzmittel wird dann an den lackfreien Stellen das Siliziumdioxid abgeätzt und anschließend wird der übrige Photolack entfernt. Das Substrat wird dann bei einer Temperatur von etwa 1000° C einer den Dotierungsstoff enthaltenden Gasphase ausgesetzt, wobei der Dotierungsstoff in die von der Siliziumdioxid-Schicht nicht bedeckten, offenen Substratstellen eindiffundiert. Beim Abkühlen des Substrats kommt der Diffusionsvorgang zum Stillstand. Das Substrat ist dann bereichsweise an den vorgesehenen Stellen dotiert. Mit Hilfe des Verfahrens lassen sich beispielsweise Transistoren, Dioden oder dergleichen elektronische Funktionsbausteine in das Substrat integrieren.

Das vorbekannte Verfahren hat jedoch den Nachteil, daß die Kosten für das zur Belichtung des Substrats benötigte Belichtungsgerät mit abnehmender Größe der herzustellenden Mikrostrukturen stark zunehmen, vergleiche F&M, Jahrgang 107 (1994), Heft 4, Seite 57 bis 60 und Heft 9, Seite 40 bis 44. Ungünstig ist dabei vor allem, daß die Auflösung des Belichtungsgerätes für die kleinste auf dem Substrat herzustellende Struktur dimensioniert werden muß, selbst dann, wenn gleichzeitig große Strukturen auf dem Substrat erzeugt werden. Die Herstellung von Festkörpern mit kleinen Strukturen ist deshalb aufwendig und kostenintensiv.

Die EP 0 412 263 A2 beschreibt ein Verfahren zur Herstellung eines Kontaktloches in einer integrierten Halbleiterschal-tung, wobei das Verfahren vorsieht, unter Verwendung einer Maske einen Halbleiterkörper zu dotieren und die Oberfläche des Halbleiterkörpers anschließend zu oxidieren, woraus eine Oxidationsschicht entsteht, die über den dotierten Halbleiterbereichen dicker als über den undotierten Halbleiterbereichen ist. Mittels eines Ätzverfahrens wird der dünnere Abschnitt der Oxidationsschicht anschließend entfernt, um den Halbleiterkörper kontaktieren zu können. Aus IBM Technical Disclosure Bulletin, Band 27, Nr. 11, April 1985, Seiten 6533 bis 6536 ist ein entsprechendes Verfahren zur Herstellung einer Isolationsschicht auf einem Halbleiterkörper, die abschnittsweise dünnere Abschnitte aufweist, bekannt, wobei durch diese dünneren Abschnitte der Isolationsschicht der Halbleiterkörper dotiert wird.

Aus JP 02 077135 (Patent Abstracts of Japan) ist ein Verfahren bekannt, bei dem auf einem Siliziumsubstrat eine Gateoxidschicht aufgebracht wird. Auf diese Gateoxidschicht wird Polysilizium abgeschieden und strukturiert, wobei eine Basisschicht unter Verwendung des strukturierten Polysiliziums als Maske hergestellt wird. Anschließend wird eine Nitridschicht abgeschieden und strukturiert, wobei eine Sourceschicht unter Verwendung der Nitridschicht als Maske hergestellt wird. Anschließend wird eine Dickoxidschicht durch selektive Oxidation hergestellt und die Nitridschicht entfernt, wobei eine hochdotierte Schicht unter Verwendung der Dickoxidschicht als Maske hergestellt wird. Anschließend wird eine Zwischenschicht abgeschieden, somit ein Kontaktloch und eine Elektrode hergestellt.

Die US 5,171,705 beschreibt ein Verfahren zur Herstellung eines DE MOS-Transistors, bei dem ein selbstjustierter Body-Anschlusskontakt hergestellt wird.

Es besteht die Aufgabe, ein Verfahren der eingangs genannten Art zu schaffen, das eine kostengünstige Herstellung eines Festkörpers mit einer kleinen Struktur ermöglicht.

Gemäß dem Oberbegriff des Anspruch 1 wird mit Hilfe einer Wärmebehandlung die eingebrachte Substanz in einen von der die Maskierungsschicht überdeckten Substratbereich eindiffundiert, so daß sich ausgehend vom Rand der Maskierungsschicht mit zunehmendem Abstand vom Rand nach innen in dem von der Maskierungsschicht überdeckten Substratbereich ein Konzentrationsgefälle der Substanz einstellt, daß danach die Maskierungsschicht zum Freilegen des darunter befindlichen Substratbereichs entfernt wird, daß eine in dem freigeleten Substratbereich befindliche oberflächennahe Schicht des Substrats mittels einer chemischen Umwandlungsreaktion in eine Beschichtung mit einem dem Konzentrationsgefälle der in dieser oberflächennahen Schicht enthaltenen Substanz entsprechenden Schichtdickenverlauf umgewandelt wird und daß in einem Teilbereich der Beschichtung, dessen Fläche kleiner ist als die von der ursprünglichen Maskierungsschicht überdeckten Substratfläche und in dem die Dicke der Beschichtung gegenüber den übrigen Teilbereichen der Beschichtung reduziert ist, wird eine Zusatzbehandlung durchgeführt, bei der das von diesem Teilbereich überdeckte Substratgebiet freigelegt und/oder in dieses Substratgebiet durch die Beschichtung hindurch wird ein Stoff eingebracht .

Mit Hilfe der Wärmebehandlung wird also der die eingebrachte Substanz aufweisende Bereich des Substrates vergrößert, wobei die Substanz bis unter den Rand der Maskierungsschicht unterdiffundiert. In dem von der Maskierungsschicht überdeckten Substratbereich stellt sich dann ein Konzentrationsgefälle mit einer ortsabhängigen Konzentration der Substanz ein, wobei die Konzentration in einer in der Grenzfläche von Maskierungsschicht und Substrat verlaufenden Substratebenemit zunehmender Entfernung vom Rand der Maskierungsschicht zum Inneren der Maskierungsschicht hin abnimmt. Die nach dem Entfernen der Maskierungsschicht auf dem ursprünglich von der Maskierungsschicht überdeckten Substratbereich mittels der chemischen Umwandlungsreaktion erzeugte Beschichtung weist an unterschiedlichen Stellen des Substratbereichs eine der Konzentration der Substanz an der jeweiligen Stelle entsprechende Dicke auf. Dabei kann je nach Wahl der chemischen Umwandlungsreaktion die Schichtdicke der Beschichtung entlang der Substratebene, ausgehend vom Rand des von der Maskierungsschicht ursprünglich überdeckten Substratbereichs zum Inneren dieses Substratbereichs hin entweder ab- oder zunehmen. Entsprechende chemische Umwandlungsreaktionen sind an sich bekannt. In vorteilhafter Weise kann die von der Schichtdicke abhängige Zusatzbehandlung für das Substrat in einem Gebiet durchgeführt werden, das kleiner ist als das ursprünglich von der Maskierungsschicht überdeckte Gebiet. So kann beispielsweise bei der Zusatzbehandlung die Beschichtung an ihrer dem Substrat abgewandten Oberfläche ganzflächig abgetragen werden, bis an den Stellen, an denen die ursprüngliche Dicke der Beschichtung geringer war als an den übrigen Stellen der Beschichtung ein Teilbereich des von der Beschichtung ursprünglich überdeckten Substratgebiets freigelegt ist. Bei der Zusatzbehandlung kann aber auch durch die Beschichtung hindurch ein chemischer Stoff in einen Teilbereich des von der Beschichtung überdeckten Substratgebiets eingebracht werden, beispielsweise durch Diffusion oder Beschuß mit Teilchen. Dabei ist das Schichtdickenprofil der Beschichtung so an die Diffusionseigenschaften des Stoffes und/oder die kinetische Energie der Teilchen angepaßt, daß der Stoff die Beschichtung nur bereichsweise an Stellen durchdringen kann, an denen die Schichtdicke eine vorbestimmte Dicke nicht überschreitet.

Bei einer Maskierungsschicht, die mittels eines photolithographischen Verfahrens auf dem Substrat erzeugt wurde, kann eine Struktur hergestellt werden, deren Abmessungen kleiner sind als die Abmessungen der kleinsten, aufgrund der begrenzten Auflösung des für das photolithographische Verfahren verwendeten Belichtungsgeräts noch zu belichtenden oder gegen das Licht abzudeckenden Substratoberfläche. In vorteilhafter Weise kann somit ein kostengünstiges Belichtungsgerät zum Einsatz kommen, dessen Auflösung geringer ist als die Abmessungen der kleinsten herzustellenden Struktur. Das Verfahren eignet sich besonders zum Herstellen von Festkörpern, die sowohl kleine als auch große Strukturen aufweisen.

Gemäß dem kennzeichnenden Teil des Anspruchs 1 wird zum Entfernen der Maskierungsschicht die seitlich an die Maskierungsschicht angrenzenden Substratbereiche mit einer Ätzmaske abgedeckt und die Maskierungsschicht danach mit einem Ätzmittel in Berührung gebracht.

Bei einer vorteilhaften Ausführungsform der Erfindung ist vorgesehen, daß die Ätzmaske mittels einer chemischen Reaktion erzeugt wird, bei der eine oberflächennahe Schicht der mit der Ätzmaske abzudeckenden Substratbereiche in ein Ätzmaskenmaterial umgewandelt wird. Die Ätzmaske kann dann auf einfache Weise und ohne die Verwendung eines zusätzlichen Photolithographieschrittes auf die von der Maskierungsschicht nicht bedeckten Oberflächenbereiche des Substrats aufgebracht werden. Die oberflächennahe Schicht kann dazu beispielsweise in einer Stickstoffatmosphäre in eine gegen ein entsprechendes Ätzmittel beständige Nitridschicht umgewandelt werden. Die Oberfläche des Festkörpers kann dann zum Entfernen der Maskierungsschicht ganzflächig mit dem Ätzmittel in Berührung gebracht werden. Wenn die Ätzmaske eine größere Dicke aufweist als die Maskierungsschicht kann auch ein Ätzmittel verwendet werden, das außer der Maskierungsschicht auch die Ätzmaske von dem Festkörper abträgt. In diesem Fall müssen die Ätzraten und die Dicken von Maskierungsschicht und Ätzmaske so aufeinander abgestimmt sein, daß nach dem vollständigen Abtragen der Maskierungsschicht mit dem Ätzmittel die Ätzmaske noch eine Restdicke aufweist und somit das Substrat weiterhin bedeckt.

Besonders vorteilhaft ist, wenn die Ätzmaske während der Wärmebehandlung durch thermische Oxidation von Substratmaterial in einer sauerstoffhaltigen Atmosphäre erzeugt wird. Dadurch kann ein zusätzlicher Fertigungsschritt für die Herstellung der Ätzmaske entfallen.

Vorteilhaft ist, wenn die chemische Umwandlungsreaktion eine Oxidationsreaktion ist. Die Beschichtung kann dann auf einfache Weise in einer sauerstoffhaltigen Atmosphäre, gegebenenfalls unter Energiezufuhr erzeugt werden. Dabei wird insbesondere bei einem Silizium-Substrat, in das ein Dotierungsmittel eindiffundiert wurde, eine deutliche Ausprägung eines von dem Konzentrationsgradient des Dotierungsmittels in dem Substratmaterial abhängigen Schichtdickenverlaufs der Beschichtung erreicht.

Bei einer vorteilhaften Ausführungsform der Erfindung ist vorgesehen, daß in dem Substratbereich, in dem die Maskierungsschicht entfernt wurde, die oberflächennahe Schicht des Substrats durch die chemische Umwandlungsreaktion in eine elektrisch isolierende Beschichtung umgewandelt wird, und daß nach dem bereichsweisen Abtragen der Beschichtung an der freigelegten Oberfläche des elektrisch leitfähigen Substratgebiets eine Metallschicht galvanisch abgeschieden wird. Dadurch ist es beispielsweise möglich, eine Mikroelektrode und/oder eine Leiterbahn mit kleinen Abmessungen auf das Substrat aufzubringen. Das Abscheiden der Metallschicht kann insbesondere stromlos galvanisch erfolgen.

Vorteilhaft ist, wenn auf die Oberfläche des Festkörpers eine vorzugsweise metallische Oberflächenschicht aufgetragen wird, und daß die Hafteigenschaften des Substratmaterials und der Beschichtung so auf das Material der Oberflächenschicht abgestimmt werden, daß diese nur an dem freigelegten Teilbereich des Substratgebietes haften bleibt. Das Material der Oberflächenschicht wird dabei so gewählt, daß es an dem freigelegten Teilbereich des Substratgebietes besser anhaftet als an den dazu benachbarten Oberflächenbereichen der Beschichtung. Eventuell nach dem Beschichten an den benachbarten Oberflächenbereichen anhaftende Schichtbereiche der Oberflächenschicht können dann beispielsweise mechanisch von der Oberfläche des Festkörpers angelöst werden, während der an dem freigelegten Teilbereich des Substratgebietes anhaftende Bereich der Oberflächenschicht weiterhin an diesem anhaften bleibt. Gegebenenfalls kann die Oberflächenschicht durch Incorporation von Fremdatomen mechanisch verspannt werden. Beim Ablösen der an der Beschichtung anhaftenden Schichtbereiche können sich dann entlang des Umgrenzungsrandes der Oberfläche des freigelegten Teilbereiches des Substratgebietes in der Oberflächenschicht Risse ausbilden, die das Ablösen der an der Beschichtung anhaftenden Bereiche dieser Oberflächenschicht erleichtern.

Bei einer Ausführungsform der Erfindung wird die oberflächennahe Schicht des Substrates mittels der chemischen Umwandlungsreaktion in eine für einen aufzubringenden chemischen Stoff undurchlässige Beschichtung umgewandelt und bei der Zusatzbehandlung wird zunächst das von einem Teilbereich dieser Beschichtung überdeckte Substratgebiet freigelegt und der Stoff anschließend in dieses Substratgebiet eingebracht. Das Einbringen des Stoffs, der insbesondere ein Dotierungsmaterial für ein Halbleitersubstrat sein kann, kann beispielsweise durch Diffusion oder Beschuß mit Teilchen erfolgen, wobei der Stoff in das freigelegte Substratgebiet eindringt, während in den von der Beschichtung überdeckten Bereichen des Substrat ein Eindringen des Stoffes in das Substrat durch die Beschichtung verhindert wird.

Bei einer Ausführungsform der Erfindung ist vorgesehen, daß der Festkörper mit einem Medium, insbesondere einem Gas, in Kontakt gebracht wird, und daß dabei das in dem freigelegten Substratgebiet befindliche Substratmaterial durch eine chemische Reaktion mit diesem Medium in ein anderes Material ungewandelt wird. Dabei werden das Medium, das Material der seitlich an den freigelegten Substratbereich angrenzenden Beschichtung und/oder die Reaktionsbedingungen vorzugsweise so gewählt, daß zwischen dem Medium und dem Material der Beschichtung eine chemische Reaktion nicht stattfindet. Die chemische Reaktion ist dann auf den freigelegten Teilbereich des Substratgebiets beschränkt, so daß dieser gezielt chemisch verändert werden kann.

Bei einer Ausführungsform der Erfindung wird nach dem Freilegen des Substratgebiets zum Einbringen einer Vertiefung in das Substratgebiet das Substratgebiet mit einem Ätzmittel für das Substratmaterial in Kontakt gebracht, gegen das die das Substratgebiet umgrenzende Beschichtung im wesentlichen chemisch beständig ist. Die Beschichtung bildet dann eine Ätzmaske für das Ätzmittel. Zum Einbringen eines im Querschnitt etwa V-förmigen Grabens in das Substratgebiet kann ein anisotropes Ätzmittel verwendet werden. Der Festkörper kann ein Teil eines Mikroreaktors sein, wobei die eingeätzte Vertiefung beispielsweise als Zuführkanal für eine in die Kammer des Mikroreaktors einzubringende Substanz und/oder als Abführkanal für eine aus der Kammer abzuleitende Substanz ausgebildet sein kann. Als Substrat wird für einen Teil eines Mikroreaktors vorzugsweise ein metallisches Material verwendet, beispielsweise Aluminium oder Silber, das eine gute Wärmeableitung aus der oder in die Kammer des Mikroreaktors ermöglicht. Nachfolgend sind Ausführungsbeispiele der Erfindung anhand der Zeichnung näher erläuert. Es zeigen zum Teil stärker schematisiert:
- Fig. 1: einen Querschnitt durch einen zum Herstellen eines Halbleiterbauelements vorgesehenen Festkörper, in dessen Substrat seitlich beidseits einer Maskierungsschicht Dotierungsbereiche eingebracht wurden,
- Fig. 2: der in Fig. 1 gezeigte Festkörper nach einer Wärmebehandlung, bei der das Dotierungsmaterial unter die Maskierungsschicht diffundiert ist,
- Fig. 3: der in Fig. 2 gezeigte Festkörper nach dem Entfernen der Maskierungsschicht und dem anschließenden Aufbringen einer ein Dickenprofil aufweisenden Beschichtung,
- Fig. 4: der in Fig. 3 gezeigte Festkörper nach einem Ätzprozeß, bei dem die Beschichtung bereichsweise von dem Substrat entfernt wurde,
- Fig. 5: der in Fig. 4 gezeigte Festkörper nach dem selektiven Aufbringen einer Metallbeschichtung und
- Fig. 6: einen Querschnitt durch eine DMOS-Transistorzelle.

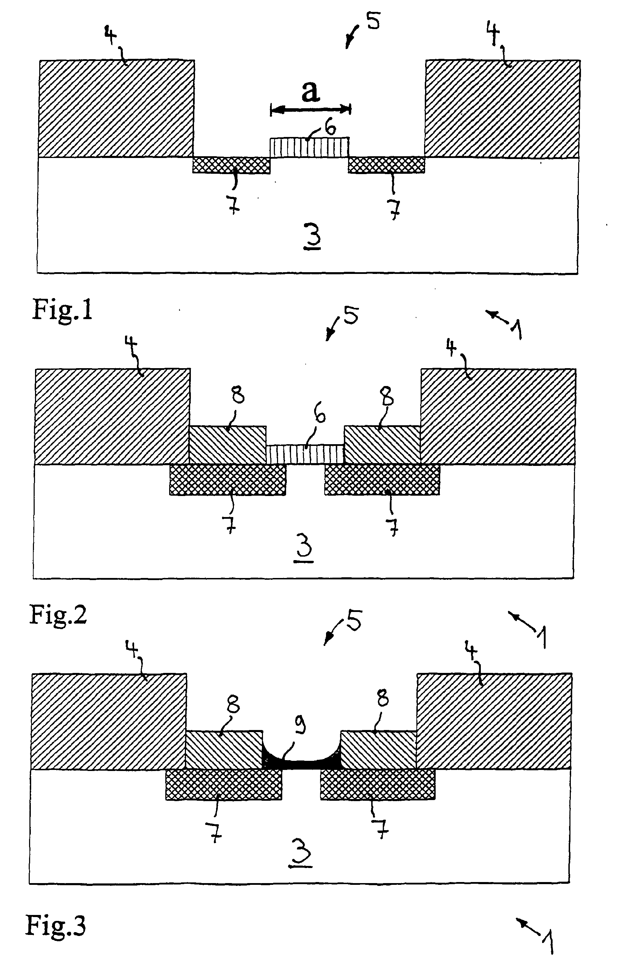

Bei einem Verfahren zum Herstellen eines als Halbleiterbauelement ausgebildeten Festkörpers 1 mit einer Mikrostruktur 2 wird ein vorzugsweise aus Silizium bestehendes Substrat 3 bereitgestellt, das an seiner Oberfläche eine vorzugsweise aus Siliziumoxid bestehende Passivierungsschicht 4 aufweist, die das Substrat 3 durchgehend bedeckt. In die Passivierungsschicht 4 wird mit einem an sich bekannten Verfahren, beispielsweise durch photolithographisches Aufbringen einer ätzbeständigen Maske und einen anschließend Naßätzprozeß, eine Öffnung 5 eingebracht, die einen Teilbereich des Substrats 3 freilegt. Zum Herstellen einer Maskierungsschicht 6 wird in der Öffnung 5 mittels eines Beschichtungsverfahren, wie zum Beispiel Chemical-Vapour-Deposition, auf den in der Öffnung 5 freigelegten Substratbereich ganzflächig eine Siliziumnitrid-Schicht aufgetragen. Anschließend wird auf diese Schicht mittels eines Photolithographie-Schrittes eine gegen ein Ätzmittel, wie zum Beispiel Phosphorsäure, beständige Ätzmaske aufgetragen, welche die Siliziumnitrid-Schicht bereichsweise abdeckt. Dann wird der Festkörper 1 zum Entfernen der nicht durch die Ätzmaske abgedeckten Bereiche der Siliziumnitrid-Schicht mit dem Ätzmittel in Berührung gebracht. Danach wird die Ätzmaske entfernt. In Fig. 1 ist erkennbar, daß die auf dem Substrat 3 verbleibenden Bereiche der Siliziumnitrid-Schicht eine einen Teilbereich des in der Öffnung 5 befindlichen Substratbereiches überdeckende Maskierungsschicht 6 bilden und daß diese Maskierungsschicht 6 seitlich beidseits von der Passivierungsschicht 4 beabstandet ist. Das Material der Maskierungsschicht 6 ist so gewählt, daß die Maskierungsschicht 6 für eine zum Dotieren des Substrats vorgesehene Substanz, wie zum Beispiel Bor oder Phosphor, undurchlässig ist.

Nach dem Fertigstellen der Maskierungsschicht 6 wird diese Substanz zum Dotieren der nicht von der Maskierungsschicht 6 überdeckten Substratbereiche in die Öffnung 5 eingebracht. Dies kann beispielsweise in der Weise geschehen, daß der Festkörper 1 einem Gasstrom ausgesetzt wird, in dem die Substanz enthalten ist. Die Substanz diffundiert dann in die von der Maskierungsschicht 6 nicht bedeckten Substratbereiche und bildet dort Dotierungszonen 7 (Fig. 1).

Nach dem Einbringen und/oder während des Einbringens der Substanz in die Dotierungsbereiche 7 wird eine Wärmebehandlung durchgeführt, bei der die eingebrachte Substanz in einen von der Maskierungsschicht 6 überdeckten Substratbereich eindiffundiert. Die Wärmebehandlung kann beispielsweise bei einer Temperatur von etwa 1000°C erfolgen. In Fig. 2 ist deutlich erkennbar, daß sich die Dotierungsbereiche 7 gegenüber Fig. 1 aufgeweitet haben und daß das Dotierungsmaterial bis unter den Rand der Maskierungsschicht 6 unterdiffundiert ist. Nach Beendigung der Wärmebehandlung ergibt sich in der Erstreckungsebene der Dotierungsbereiche 7, jeweils ausgehend vom Rand der Maskierungsschicht 6 in den von der Maskierungsschicht 6 überdeckten Substratbereich mit zunehmendem Abstand vom Rand der Maskierungsschicht eine Abnahme der Konzentration der Substanz.

Während der Wärmebehandlung ist der Festkörper 1 einer sauerstoffhaltigen Atmosphäre ausgesetzt, in der auf den nicht von der Maskierungsschicht 6 überdeckten Substratbereich in der Öffnung 5 eine Oxidschicht aufwächst, die eine Ätzmaske 8 bildet, die gegen ein zum Entfernen der Maskierungsschicht 6 vorgesehenes Ätzmittel, wie zum Beispiel Phosphorsäure, beständig ist. Mit diesem Ätzmittel wird die Maskierungsschicht 6 nach Beendigung der Wärmebehandlung zum Entfernen der Maskierungsschicht 6 in Berührung gebracht, wobei der unter der Maskierungsschicht 6 befindliche Substratbereich freigelegt wird.

Danach wird eine in dem freigelegten Substratbereich befindliche oberflächennahe Schicht des Substrats 3 mittels einer chemischen Umwandlungsreaktion in einer sauerstoffhaltigen Atmosphäre in eine Siliziumdioxid-Beschichtung 9 umgewandelt. Die lokale Dicke dieser Beschichtung 9 ist von der Konzentration der in den an der chemischen Umwandlungsreaktion jeweils beteiligten Substratbereich eindiffundierten Substanz in dem Substratmaterial abhängig. In Fig. 3 ist deutlich erkennbar, daß die Dicke der Beschichtung 9 in der Erstreckungsebene der Beschichtung 9 ausgehend vom Rand der Beschichtung 9 zur Mitte der Beschichtung 9 hin abnimmt, und zwar entsprechend der jeweiligen Konzentrationsabnahme der Substanz in dem Substrat 3.

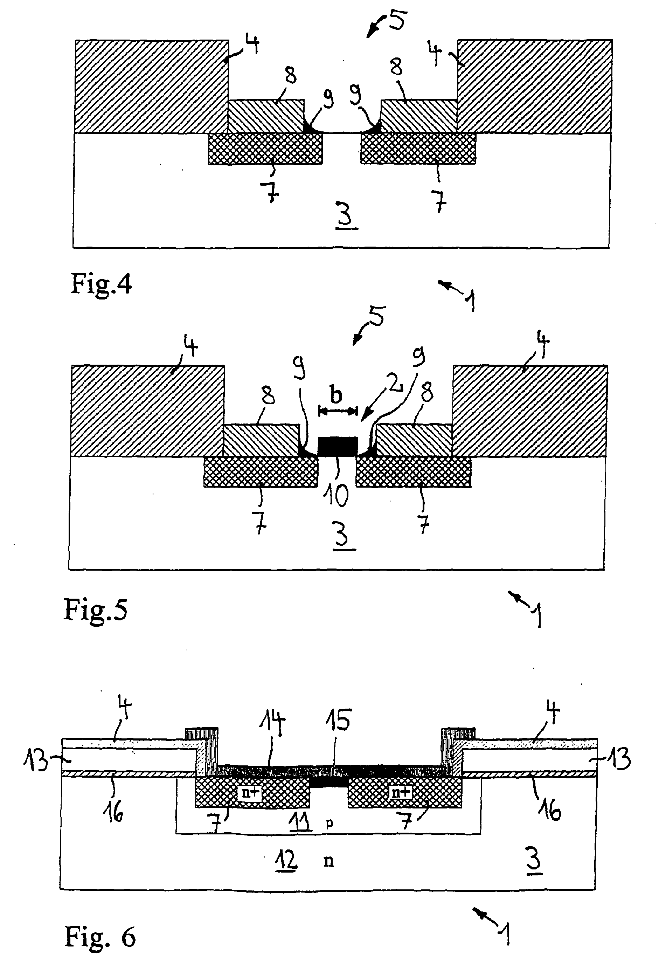

Bei dem Ausführungsbeispiel nach Fig. 4 wird die Beschichtung 9 einem Ätzmittel ausgesetzt, daß das Material von der dem Substrat 3 abgewandten Oberfläche der Beschichtung 9 wegätzt. Der Ätzprozeß wird gestoppt, wenn ein Teilbereich der Beschichtung 9, in dem die ursprüngliche Dicke der Beschichtung 9 gegenüber den benachbarten Teilbereichen der ursprünglichen Beschichtung 9 reduziert ist, vollständig abgetragen und das von diesem Teilbereich überdeckte Substrat 3 freigelegt ist. In Fig. 4 ist erkennbar, daß nach Beendigung des Ätzprozesses der von der ursprünglichen Maskierungsschicht 6 überdeckte Substratbereich nur noch an seinen Randbereichen von der Beschichtung 9 überdeckt ist und daß ein Substratbereich, der kleiner ist als der von der ursprünglichen Maskierungsschicht 6 überdeckte Substratbereich freigelegt ist. Während des Ätzens der Beschichtung 9 werden zwar auch oberflächennahe Schichten von der Passivierungsschicht 4 und der Ätzmaske 9 abgetragen, jedoch ist die Dicke der Passivierungsschicht 4 und die der Ätzmaske 9 so groß gewählt, daß diese nur über einen Teil ihrer Dicke weggeätzt werden und somit das darunter befindliche Substrat-Material nach Beendigung des Ätzvorganges weiterhin abgedeckt bleibt.

Bei dem Ausführungsbeispiel nach Fig. 5 besteht die Beschichtung 9 aus einem elektrisch isolierenden Material. Nach dem bereichsweisen Abtragen der Beschichtung 9 wird an der freigelegten Oberfläche des Substrats 3 eine Metallschicht 10 galvanisch abgeschieden, die beispielsweise eine Elektrode oder eine Leiterbahn bilden kann. In Fig. 5 ist deutlich erkennbar, daß die Abmessungen a der Metallschicht 10 kleiner sind als die Abmessungen b der ursprünglichen Maskierungsschicht 6. Mit dem Verfahren kann also eine Mikrostruktur 2 hergestellt werden, deren Abmessungen kleiner sind als die Auflösung einer zum Herstellen der photolithographisch aufgebrachten Maskierungsschicht 6 verwendeten Belichtungseinrichtung. Somit können die zusätzlichen Kosten für eine hochauflösende Belichtungseinrichtung eingespart werden.

In das durch das bereichsweise Entfernen der Beschichtung 9 freigelegte Substratgebiet kann ein Stoff eingebracht werden. Das Material der Beschichtung 9 wird dazu so gewählt, daß der nach dem Freilegen des Substratgebiets auf dem Substrat 3 verbleibende Rest der Beschichtung 9 für den einzubringenden Stoff zumindest bereichsweise undurchlässig ist. Zum Einbringen des Stoffes wird der Festkörper mit dem beispielsweise in einer Gasphase befindlichen Stoff in Kontakt gebracht, wobei der Stoff im wesentlichen nur in die freigelegten Substratbereiche eindiffundiert, während die übrigen Substratbereiche von dem Stoff freibleiben.

In Fig. 6 ist eine nach dem Verfahren hergestellte DMOS-Transistorzelle gezeigt, bei welcher der Stoff ein Dotierungsmaterial ist, das in eine p⁺-Zone für eine Freilaufdiode eingebracht wurde. Die beidseits der p⁺-Zone 15 angeordneten Dotierungsbereiche 7 sind als n⁺-Sourcegebiete ausgebildet, die in einen p-dotierten Substratbereich 11 eingebettet sind. Dieser p-dotierte Substratbereich 11 ist seinerseits ineinenn-dotierten Substratbereich 12 eingelassen. Außerdem sind in Fig. 6 Gate-Kontakte 13, eine Passivierungsschicht 4, ein Source-Kontakt 14 und eine Gateoxid-Schicht 16 erkennbar.

Bei dem Verfahren zum Herstellen eines Festkörpers 2 mit einer Mikrostruktur 2 wird also die Oberfläche eines Substrats 3 mit einer für eine aufzubringende Substanz undurchlässigen Maskierungsschicht 6 versehen. Danach wird die Substanz in von der Maskierungsschicht 6 nicht bedeckte Substratbereiche eingebracht. Mit Hilfe einer Wärmebehandlung wird die Substanz in einen von der die Maskierungsschicht 6 überdeckten Substratbereich eindiffundiert, so daß sich ausgehend vom Rand der Maskierungsschicht 6 mit zunehmendem Abstand vom Rand nach innen in dem von der Maskierungsschicht 6 überdeckten Substratbereich ein Konzentrationsgefälle der Substanz einstellt. Danach wird die Maskierungsschicht 6 zum Freilegen des darunter befindlichen Substratbereichs entfernt und eine in dem freigeleten Substratbereich befindliche oberflächennahe Schicht des Substrats 3 wird mittels einer chemischen Umwandlungsreaktion in eine Beschichtung 9 umgewandelt, die einen dem Konzentrationsgefälle der in der oberflächennahen Schicht enthaltenen Substanz entsprechenden Schichtdickenverlauf aufweist. In einem Teilbereich der Beschichtung 9, in dem die Dicke der Beschichtung 9 reduziert ist, wird eine Zusatzbehandlung durchgeführt.

## Patentansprüche

1. Verfahren zum Herstellen eines eine Mikrostruktur aufweisenden Festkörpers (1), insbesondere eines Halbleiterbauelements, wobei die Oberfläche eines Substrats (3) mit einer für eine aufzubringende Substanz undurchlässigen Maskierungsschicht (6) versehen und die Substanz danach in von der Maskierungsschicht (6) nicht bedeckte Substratbereiche eingebracht wird, wobei mit Hilfe einer Wärmebehandlung die eingebrachte Substanz in einen von der die Maskierungsschicht (6) überdeckten Substratbereich eindiffundiert wird, so daß sich ausgehend vom Rand der Maskierungsschicht (6) mit zunehmendem Abstand vom Rand nach innen in dem von der Maskierungsschicht (6) überdeckten Substratbereich ein Konzentrationsgefälle der Substanz einstellt, daß danach die Maskierungsschicht (6) zum Freilegen des darunter befindlichen Substratbereichs entfernt wird, daß eine in dem freigelegten Substratbereich befindliche oberflächennahe Schicht des Substrats (3) mittels einer chemischen Umwandlungsreaktion in eine Beschichtung (9) mit einem dem Konzentrationsgefälle der in dieser oberflächennahen Schicht enthaltenden Substanz entsprechenden Schichtdickenverlauf umgewandelt wird und daß in einem Teilbereich der Beschichtung (9), dessen Fläche kleiner ist als die von der ursprünglichen Maskierungsschicht (6) überdeckte Substratfläche und in dem die Dicke der Beschichtung (9) gegenüber den übrigen Teilbereichen der Beschichtung (9) reduziert ist, eine Zusatzbehandlung durchgeführt wird, bei der das von diesem Teilbereich überdeckte Substratgebiet freigelegt und/oder in dieses Substratgebiet durch die Beschichtung (9) hindurch ein Stoff eingebracht wird,
**dadurch gekennzeichnet,**
**daß** zum Entfernen der Maskierungsschicht (6) die seitlich an die Maskierungsschicht (6) angrenzenden Substratbereiche mit einer Ätzmaske (8) abgedeckt und die Maskierungsschicht (6) danach mit einem Ätzmittel in Berührung gebracht wird.

2. Verfahren nach Anspruch 1, **dadurch gekennzeichnet, daß** die Ätzmaske (8) mittels einer chemischen Reaktion erzeugt wird, bei der eine oberflächennahe Schicht der mit der Ätzmaske (8) abzudeckenden Substratbereiche in ein Ätzmaskenmaterial umgewandelt wird.

3. Verfahren nach Anspruch 1 oder 2, **dadurch gekennzeichnet, daß** die Ätzmaske (8) während der Wärmebehandlung durch thermische Oxidation von Substratmaterial in einer sauerstoffhaltigen Atmosphäre erzeugt wird.

4. Verfahren nach einem der Ansprüche 1 bis 3, **dadurch gekennzeichnet, daß** die chemische Umwandlungsreaktion eine Oxidationsreaktion ist.

5. Verfahren nach einem der Ansprüche 1 bis 4, **dadurch gekennzeichnet, daß** in dem Substratbereich, in dem die Maskierungsschicht (6) entfernt wurde, die oberflächennahe Schicht des Substrats (3) durch die chemische Umwandlungsreaktion in eine elektrisch isolierende Beschichtung (9) umgewandelt wird, und daß nach dem bereichsweisen Abtragen der Beschichtung (9) an der freigelegten Oberfläche des elektrisch leitfähigen Substratgebiets eine Metallschicht (10) galvanisch abgeschieden wird.

6. Verfahren nach einem der Ansprüche 1 bis 5, **dadurch gekennzeichnet, daß** auf die Oberfläche des Festkörpers (1) eine vorzugsweise metallische Oberflächenschicht aufgetragen wird, und daß die Hafteigenschaften des Substratmaterials und der Beschichtung so auf das Material der Oberflächenschicht abgestimmt werden, daß diese nur an dem freigelegten Teilbereich des Substratgebiets haften bleibt.

7. Verfahren nach einem der Ansprüche 1 bis 6, **dadurch gekennzeichnet, daß** die oberflächennahe Schicht des Substrats (3) mittels der chemischen Umwandlungsreaktion in eine für einen aufzubringenden chemischen Stoff undurchlässige Beschichtung (9) umgewandelt wird, und daß bei der Zusatzbehandlung zunächst das von einem Teilbereich dieser Beschichtung (9) überdeckte Substratgebiet freigelegt und der Stoff anschließend in dieses Substratgebiet eingebracht wird.

8. Verfahren nach einem der Ansprüche 1 bis 7, **dadurch gekennzeichnet, daß** der Festkörper (1) mit einem Medium, insbesondere einem Gas, in Kontakt gebracht wird, und daß dabei das in dem freigelegten Substratgebiet befindliche Substratmaterial durch eine chemische Reaktion mit diesem Medium in ein anderes Material umgewandelt wird.

9. Verfahren nach einem der Ansprüche 1 bis 8, **dadurch gekennzeichnet, daß** nach dem Freilegen des Substratgebiets zum Einbringen einer Vertiefung in das Substratgebiet das Substratgebiet mit einem Ätzmittel für das Substratmaterial in Kontakt gebracht wird, gegen das die das Substratgebiet umgrenzende Beschichtung (9) im wesentlichen chemisch beständig ist.

## Claims

1. Method for producing a solid body (1) in particular a semiconductor component comprising a microstructure, the surface of a substrate (3) being provided with a masking layer (6) that is impermeable to a substance to be applied and the substance then being introduced into substrate regions not covered by the masking layer (6) the substance introduced being diffused with the aid of a thermal treatment, into a substrate region covered by the masking layer (6), with the result that a concentration gradient of the substance is established proceeding from the edge of the masking layer (6) with increasing distance from the edge inwards in the substrate region covered by the masking layer (6), the masking layer (6) then being removed in order to uncover the substrate region situated underneath, a layer of the substrate (3) that is near the surface and is situated in the uncovered substrate region being converted, by means of a chemical conversion reaction, into a coating (9) having a layer thickness profile corresponding to the concentration gradient of the substrate contained in said layer that is near the surface, and an additional treatment being carried out in a partial region of the coating (9), the area of which partial region is smaller than the substrate area covered by the original masking layer (6) and in which partial region the thickness of the coating (9) is reduced by comparison with the remaining partial regions of the coating (9), in which additional treatment the substrate zone covered by said partial region is uncovered and/or a substance is introduced into said substrate zone through the coating (9),
**characterized in that**,
in order to remove the masking layer (6), the substrate regions which laterally adjoin the masking layer (6) are covered with an etching mask (8) and the masking layer (6) is then brought into contact with an etchant.

2. Method according to Claim 1, **characterized in that** the etching mask (8) is produced by means of a chemical reaction in which a layer - which is near the surface - of the substrate regions to be covered with the etching mask (8) is converted into an etching mask material.

3. Method according to Claim 1 or 2, **characterized in that** the etching mask (8) is produced during the thermal treatment by thermal oxidation of substrate material in an oxygen-containing atmosphere.

4. Method according to one of Claims 1 to 3,
**characterized in that** the chemical conversion reaction is an oxidation reaction.

5. Method according to one of Claims 1 to 4,
**characterized in that**, in the substrate region in which the masking layer (6) has been removed, the layer of the substrate (3) that is near the surface is converted into an electrically insulating coating (9) by the chemical conversion reaction, and **in that** a metal layer (10) is electrodeposited after region-by-region removal of the coating (9) at the uncovered surface of the electrically conductive substrate zone.

6. Method according to one of Claims 1 to 5,
**characterized in that** a preferably metallic surface layer is applied to the surface of the solid body (1), and **in that** the adhesion properties of the substrate material and of the coating are coordinated with the material of the surface layer such that the latter adheres only to the uncovered partial region of the substrate zone.

7. Method according to one of Claims 1 to 6,
**characterized in that** the layer of the substrate (3) that is near the surface is converted, by means of the chemical conversion reaction, into a coating (9) that is impermeable to a chemical substance to be applied, and **in that**, during the additional treatment, firstly the substrate zone covered by a partial region of said coating (9) is uncovered and the substance is subsequently introduced into said substrate zone.

8. Method according to one of Claims 1 to 7,
**characterized in that** the solid body (1) is brought into contact with a medium, in particular a gas, and **in that** the substrate material situated in the uncovered substrate zone is in the process converted into a different material by a chemical reaction with said medium.

9. Method according to one of Claims 1 to 8,
**characterized in that**, after the substrate zone has been uncovered, for the purpose of introducing a depression into the substrate zone, the substrate zone is brought into contact with an etchant for the substrate material with respect to which the coating (9) delimiting the substrate zone is substantially chemically resistant.

## Revendications

1. Procédé de fabrication d'un corps solide (1) qui présente une microstructure, en particulier un composant semi-conducteur, dans lequel la surface d'un substrat (3) est dotée d'une couche de masquage (6) imperméable vis-à-vis d'une substance à appliquer, la substance étant ensuite apportée dans les parties du substrat non recouvertes par la couche de masquage (6), la substance apportée étant amenée à diffuser à l'aide d'un traitement thermique dans une partie du substrat recouverte par la couche de masquage (6) de manière à établir une chute de la concentration de la substance partant du bord de la couche de masquage (6) et en s'éloignant progressivement du bord en direction de l'intérieur de la partie du substrat recouverte par la couche de masquage (6), ensuite la couche de masquage (6) étant ensuite enlevée pour libérer la partie du substrat située en dessous d'elle, une couche du substrat (3) proche de la surface et située dans la partie libérée du substrat étant convertie au moyen d'une réaction de conversion chimique en un revêtement (9) dont l'évolution de l'épaisseur de la couche correspond à la chute de concentration de la substance contenue dans cette couche proche de la surface, tandis que dans une partie de revêtement (9) dont la surface est plus petite que la surface du substrat recouverte par la couche initiale de masquage (6) et dans laquelle l'épaisseur du revêtement (9) est plus petite que dans les autres parties du revêtement (9), on réalise un traitement supplémentaire dans lequel le domaine du substrat recouvert par cette partie est libéré et/ou dans lequel une matière est introduite dans ce domaine du substrat à travers le revêtement (9),
**caractérisé en ce que**
pour enlever la couche de masquage (6), les parties du substrat adjacentes à la couche de masquage (6) sont recouvertes par un masque de gravure (8), la couche de masquage (6) étant ensuite mise en contact avec un agent de gravure.

2. Procédé selon la revendication 1, **caractérisé en ce que** le masque de gravure (8) est créé au moyen d'une réaction chimique dans laquelle une couche proche de la surface des zones du substrat qui doivent être recouvertes par le masque de gravure (8) est convertie en un matériau de masque de gravure.

3. Procédé selon les revendications 1 ou 2, **caractérisé en ce que** le masque de gravure (8) est créé pendant le traitement thermique par oxydation thermique du matériau de substrat dans une atmosphère qui contient de l'oxygène.

4. Procédé selon l'une quelconque des revendications 1 à 3, **caractérisé en ce que** la réaction de conversion chimique est une réaction d'oxydation.

5. Procédé selon l'une quelconque des revendications 1 à 4, **caractérisé en ce que** dans la partie du substrat dans laquelle la couche de masquage (6) a été enlevée, la couche du substrat (3) proche de la surface est convertie par la réaction de conversion chimique en un revêtement électriquement isolant (9) et **en ce qu'**après l'enlèvement de parties du revêtement (9), une couche métallique (10) est déposée galvaniquement sur la surface libérée du domaine du substrat rendu électriquement conducteur.

6. Procédé selon l'une quelconque des revendications 1 à 5, **caractérisé en ce que** l'on applique une couche superficielle de préférence métallique sur la surface du corps solide (1) et **en ce que** les propriétés d'adhérence du matériau du substrat et du revêtement sont accordées à celles du matériau de la couche de surface de telle sorte que cette dernière n'adhère qu'à la partie libérée du domaine du substrat.

7. Procédé selon l'une quelconque des revendications 1 à 6, **caractérisé en ce que** la couche du substrat (3) proche de la surface est convertie au moyen de la réaction de conversion chimique en un revêtement (9) imperméable vis-à-vis d'une substance chimique à appliquer et **en ce que** lors du traitement supplémentaire, le domaine du substrat recouvert par une partie de ce revêtement (9) est libéré et la substance est ensuite apportée dans ce domaine du substrat.

8. Procédé selon l'une quelconque des revendications 1 à 7, **caractérisé en ce que** le corps solide (1) est mis en contact avec un fluide et en particulier avec un gaz et **en ce que** le matériau du substrat situé dans le domaine libéré du substrat est ainsi converti en un autre matériau par réaction chimique avec ce fluide.

9. Procédé selon l'une quelconque des revendications 1 à 8, **caractérisé en ce qu'**après la libération du domaine du substrat et pour ménager un creux dans le domaine du substrat, le domaine du substrat est mis en contact avec un agent de gravure du matériau de substrat vis-à-vis duquel le revêtement (9) qui délimite le domaine du substrat résiste essentiellement sur le plan chimique.
